# EUROPEAN PATENT SPECIFICATION

(11) **EP 2 434 345 B1**
(45) Date of publication and mention of the grant of the patent: **03.07.2013**
(21) Application number: 10194072.4
(22) Date of filing: 08.12.2010
(51) Int. Cl.: G03F 7/20, G03F 1/00

(54) **Method and system for evaluating euv mask flatness**
Verfahren und System zur Beurteilung der Flachheit von EUV Masken
Procédé et système d'évaluation de la planéité de masques EUV

(30) Priority: 27.09.2010 US 386967 P
(43) Date of publication of application: 28.03.2012
(73) Proprietor: IMEC, 3001 Leuven (BE); Intel Corporation (INTEL), Santa Clara, CA 95052-8119 (US)
(72) Inventor: Lorusso, Gian Francesco, 3090 Overijse (BE); Lee, Sang, Saratoga, CA 95070 (US)
(74) Representative: Wauters, Davy Erik Angelo

(56) References cited:
- US-A1- 2001 019 625
- US-A1- 2008 079 927

## Description

### Field of the invention

The present invention generally relates to lithography, more specifically lithography for semiconductor processing. More particularly, this invention relates to a method and system for evaluating the topography and/or curvature of a lithographical element.

### Background of the invention

Optical lithography nowadays often uses wavelengths of 248 nm or 193 nm. With 193 nm immersion lithography integrated circuit (IC) manufacturing is possible down to 45 nm or even down to 32 nm node. However for printing in sub-32 nm half pitch node, this wavelength is probably not satisfactory due to theoretical limitations, unless double patterning is used. Instead of using wavelengths of 193 nm, a more advanced technology has been introduced, also referred to as extreme ultraviolet lithography (EUV lithography), which uses wavelengths of 10 nm to 14 nm, with as typical value 13.5 nm. This technique was previously also known as soft X-ray lithography more specifically using wavelengths in the range of 2 nm to 50 nm.

In optical lithography at some wavelengths in the deep ultra violet (DUV) range, the electromagnetic radiation is transmitted by most materials, including glass used for conventional lenses and masks.

At short wavelengths however, e.g. for extreme ultraviolet lithography and soft X-ray lithography, the electromagnetic radiation is absorbed by most materials, including glass used for conventional lenses and masks. Therefore a completely different tool is necessary for performing EUV lithography compared to conventional optical lithography. Instead of using lenses, such an imaging system presently relies on all-reflective optics and therefore is composed of reflective optical elements, also referred to as catoptric elements, for example mirrors. These reflective optical elements, e.g. mirrors typically are coated with multilayer structures designed to have a high reflectivity (up to 70%) at the 13.5 nm wavelength. Furthermore, since air will also absorb EUV light, a vacuum environment also is required.

The introduction of EUV lithography has also introduced a number of challenges to overcome. One of these challenges relates to the flatness requirement of the chucked mask (or reticle). Due to non-flatness of the mask unacceptable overlay errors may occur. According to SEMI EUV mask and mask chucking standards (P37, specification for extreme ultraviolet lithography masks substrates and P40, specification for mounting requirements and alignment reference location for extreme ultraviolet lithography masks) stringent mask flatness requirements are set, being a mask flatness error less than 30 nm peak-to-peak valley for the 22 nm technology node and beyond.

In order to meet these stringent requirements for (chucked) mask flatness the use of an electrostatic chuck has been introduced in EUV lithography and further optimized for mask blank flatness control. Offline interferometric metrology tools have been developed to enable electrostatic chucking experimentation as for example published in Proceedings of SPIE Vol. 6607, 2007 by Shu. Nataraju et al. discloses in Proceedings of SPIE Vol. 6517, 2007 flatness measurements of the chucked mask are performed using a Zygo interferometer and introduced in a finite element model to determine the geometry of the reticle and chuck surface. However these models do not incorporate the chuck properties which may alter from tool to tool. Moreover both examples are ex-situ, i.e. outside the lithographic tool measurement techniques.

The use of an interferometer to determine the flatness of an optical element is known in the prior art. The technique is based on emitting light from an interferometric light source and measuring the interference pattern of the reflected light form the mask and from a reference object by a detector. It is a disadvantage of this technique that both a test or reference object and a detector are necessary in a lithographic environment. This technique has also never been applied to qualify the overall flatness of the mask in situ in a lithographic system.

In order to improve the flatness of the mask in a lithographic tool a system is disclosed in United States patent application US 2008/0079927 by Vernon. A holder is disclosed to carry a lithographic mask in a flattened condition. The holder comprises a plurality of independently controllable actuators coupled to the substrate and to the lithographic mask to flatten the lithographic mask.

The criticality of the mask flatness requirements in EUV lithography implies the need for methods and systems for evaluating and characterizing the flatness of (chucked) lithographic mask in situ, more specifically a EUV lithographic mask. In United States patent US 6,950,176 an EUV lithography mask flatness evaluating system is disclosed. The system comprises a contactless capacitance probe. By scanning the chucked EUV mask with the capacitance probe, a flatness profile may be determined. It is a disadvantage of this method that the mask or reticle has to be completely scanned in order to get an overview of the flatness of the mask/reticle. It is another disadvantage of this method that a UHV capacitance gauge needs to be installed in-situ without interfering the present EUV-exposure tools during EUV exposure.

There is a need for methods and systems for mask inspection which overcome disadvantages mentioned above.

### Summary of the invention

It is an object of the present invention to provide good methods and systems for monitoring flatness or non-flatness of a lithographic optical element. It is an advantage of embodiments according to the present invention that the flatness or non-flatness of a lithographic optical element may be monitored in-situ, i.e. in the lithographic process system.

The present invention relates to a method for evaluating a lithographic system or component thereof, the method comprising directing electromagnetic radiation of a second wavelength or wavelength range, different from electromagnetic radiation of a first wavelength or wavelength range for lithographic processing in the lithographic system, to a lithographic optical element and detecting at least part of the electromagnetic radiation being reflected from the lithographic optical element at a substrate comprising a photosensitive layer, thereafter evaluating the detected electromagnetic radiation, and determining from the evaluation of the exposed photosensitive layer a topographical parameter of the lithographic optical element and/or a holder thereof.

It is an advantage of embodiments according to the present invention that the flatness or non-flatness of a lithographic optical element may be characterized with a user-friendly metrology system and a set of tools usually available in a semiconductor manufacturing environment.

It is an advantage of embodiment according to the present invention that chucking repeatability may be monitored.

The method also may comprises obtaining the substrate with photosensitive layer, obtaining the lithographic optical element and obtaining an energy source for emitting the electromagnetic radiation of the second wavelength or wavelength range in the lithographic system.

The lithographic system may be an extreme ultraviolet (EUV) lithographic system.

The electromagnetic radiation of the first wavelength or wavelength range for lithographic processing in the lithographic system may be extreme ultraviolet (EUV) electromagnetic radiation and the electromagnetic radiation of the second wavelength or wavelength range for lithographic processing in the lithographic system may be deep ultraviolet (DUV) electromagnetic radiation. Simultaneously with electromagnetic radiation of the second wavelength or wavelength range, electromagnetic radiation of the first wavelength or wavelength range may be directed towards the optical lithographic element, but at least part of the electromagnetic radiation of the first wavelength or wavelength range may be absorbed in the optical lithographic element.

It is an advantage of embodiments according to the present invention that the flatness or non-flatness of a lithographic optical element may be monitored using the light source of the lithographic tool, i.e. the same source used for lithographic process of a semiconductor substrate.

The electromagnetic radiation of the first wavelength or wavelength range may be induced by a different radiation source than the electromagnetic radiation of the second wavelength or wavelength range.

Evaluating the detected electromagnetic radiation may comprise optically evaluating the substrate comprising the photosensitive layer. Optically evaluating may comprise in-situ optically evaluating.

Evaluating may comprise evaluating any of height differences or fringes in the exposed photosensitive layer.

The method may comprising, after said determining a topographical parameter, correcting the lithographic optical element or a holder thereof taking into account the determined topographical parameter. It is an advantage of embodiments according to the present invention that results on flatness or non-flatness of a lithographic optical element may be provided as feedback directly to the lithographic process system for any possible correction.

It is an advantage of embodiments according to the present invention that overlay errors in the exposed wafer or substrate may be minimized.

The lithographic optical element may be positioned on a holder, the method further comprising repeating said directing and evaluating step in a second lithographic process system using a lithographic optical element and irradiation sources having the same characteristics, wherein determining a topographical parameter of the lithographic optical element and/or a holder thereof comprises determining a difference in topography between components of the first and second lithographic process system, allowing a lithographic process system tool-to-tool evaluation. The difference in topography between components of the first and second lithographic process system may be a difference between the holder of the first lithographic optical element and the second lithographic optical element. It is an advantage of embodiments according to the present invention that lithographic tool-to-tool variations can easily be taken into account when assessing flatness or non-flatness of a lithographic optical element.

The present invention also relates to a lithographic system, the system comprising a means for holding a mask or a mask blank, a first irradiation source for generating a first irradiation beam for lithographic processing of a substrate, a second irradiation source, different from the first irradiation source, for generating a second irradiation beam, a wavelength or wavelength range of said second irradiation beam being substantially longer than a wavelength or wavelength range of the first irradiation beam, for evaluating a topography of the mask or the mask blank, a means for holding a substrate comprising a photosensitive layer for detecting at least part of the second irradiation beam, and irradiation optics for guiding the irradiation beam from the first and second irradiation source towards the photosensitive layer via the mask or the mask blank.

The lithographic system may be an extreme ultraviolet lithographic process system, the first irradiation source being an irradiation source for extreme ultraviolet lithographic processing of the substrate and the second irradiation source is a deep ultraviolet irradiation source.

The lithographic system furthermore may comprise an EUV filter for temporarily selectively preventing at least part of the first irradiation beam to be incident on the photosensitive layer. Such a filter may be an absorbing layer on a lithographic element, such as for example an absorbing layer on a mask or mask blank.

The system furthermore may comprise a processing means programmed for evaluating the detected second irradiation beam and/or a processing means programmed for deriving a topographical parameter of the mask or mask blank or its holder in the lithographic process system.

The present invention in one aspect relates to a method for evaluating the topography of a lithographic optical element, the method comprising the steps of obtaining, e.g. providing, a substrate comprising a photosensitive layer, obtaining, e.g. providing, the lithographic optical element, obtaining, e.g. providing, an energy source emitting an electromagnetic radiation in a wavelength range, directing the electromagnetic radiation to the substrate thereby exposing the photosensitive layer, said directing comprising directing the electromagnetic radiation to the lithographic optical element, at least part of the electromagnetic radiation being reflected from the lithographic optical element towards the photosensitive layer of the substrate. The method also comprises thereafter evaluating the exposed photosensitive layer and determining from the evaluation of the exposed photosensitive layer the topography of the lithographic optical element. According to embodiments providing the substrate, providing the lithographic optical element and providing the energy source comprises providing the substrate, providing the lithographic optical element and providing the energy source in a lithographic process system and/or a lithographic metrology system.

The present invention also relates to a method for evaluating the topography of a lithographic optical element, the method comprising the steps of obtaining, e.g. providing, a substrate comprising a photosensitive layer; obtaining, e.g. providing, the lithographic optical element, the lithographic optical element being a mask blank, obtaining, e.g. providing, an EUV source emitting an electromagnetic radiation directing the electromagnetic radiation to the substrate thereby exposing the photosensitive layer, said directing comprising directing the electromagnetic radiation to the mask blank, wherein part of the electromagnetic radiation is absorbed by the mask blank and at least another part of the electromagnetic radiation being reflected from the mask blank towards the photosensitive layer of the substrate. The method also comprises thereafter evaluating the exposed photosensitive layer and determining from the evaluation of the exposed photosensitive layer the topography of the mask blank. Part of the electromagnetic radiation may be preferably the EUV part. The another part of the electromagnetic radiation may be preferably the DUV part.

The present invention furthermore relates to a method for evaluating the topography of a lithographic optical element, the method comprising the steps of obtaining, e.g. providing, a substrate comprising a photosensitive layer, obtaining, e.g. providing, the lithographic optical element, the lithographic optical element comprising a mask, obtaining, e.g. providing, a DUV source emitting an electromagnetic radiation, directing the electromagnetic radiation to the substrate thereby exposing the photosensitive layer, said directing comprising directing the electromagnetic radiation to the mask, the electromagnetic radiation being reflected from the mask towards the photosensitive layer of the substrate. The method also comprises thereafter evaluating the exposed photosensitive layer and determining from the evaluation of the exposed photosensitive layer the topography of the mask.

In one aspect, the present invention also relates to a lithographic system, the system comprising an irradiation source for generating an irradiation beam, a means for holding a mask or a mask blank, a means for holding a substrate, irradiation optics for guiding the irradiation beam from the irradiation source towards the substrate via a mask or a mask blank, and a second irradiation source for evaluating the mask or the mask blank.

The present invention furthermore relates to a method for lithographic tool-to-tool inspection. The method comprises the steps of providing a first and a second lithographic optical system, the first lithographic optical system comprising a first substrate with a first photosensitive layer and a first lithographic optical element and a first energy source, the second lithographic optical system comprising a second substrate with a second photosensitive layer and a second lithographic optical element and a second energy source wherein the characteristics for the first and second energy source and for the first and second lithographic optical element are respectively the same. The method also comprises directing electromagnetic radiation comprising a wavelength range centered around a first single wavelength from the first and second energy source to the first and second substrate respectively thereby exposing the photosensitive layer of the first and second substrate, said directing comprising directing the electromagnetic radiation to the first and second lithographic optical element respectively, the electromagnetic radiation being reflected from the first and second lithographic optical element respectively towards the photosensitive layer of the first and second substrate respectively. The method also comprises thereafter evaluating the exposed photosensitive layer of the first and second substrate and determining the topography variation between the first and second lithographic optical system by comparing the evaluated exposed photosensitive layer of the first and second substrate. Determining the topography variation between the first and second lithographic optical system may be more particular differences in topography of the chuck whereupon the lithographic optical element is attached.

The present invention also relates to a method for lithographic process tool-to-tool evaluation, the method comprising obtaining, e.g. providing, in a lithographic process tool, obtaining, e.g. providing, a substrate comprising a photosensitive layer; obtaining, e.g. providing, a lithographic optical element on a chuck; obtaining, e.g. providing, an energy source emitting an electromagnetic radiation, and directing in the lithographic process tool the electromagnetic radiation to the substrate thereby exposing the photosensitive layer, said directing comprising directing the electromagnetic radiation to the lithographic optical element, the electromagnetic radiation being reflected from the lithographic optical element towards the photosensitive layer of the substrate. The method also comprises thereafter providing in another lithographic process tool. The method further comprises obtaining, e.g. providing, another substrate comprising another photosensitive layer, obtaining, e.g. providing, the lithographic optical element on another chuck, obtaining, e.g. providing, another energy source emitting an electromagnetic radiation and directing in the another lithographic process tool the electromagnetic radiation to the another substrate thereby exposing the photosensitive layer, said directing comprising directing the electromagnetic radiation to the lithographic optical element, the electromagnetic radiation being reflected from the another lithographic optical element towards the photosensitive layer of the another substrate. The method further comprises thereafter evaluating the exposed photosensitive layer of the substrate and the another substrate and determining from the evaluation of the exposed photosensitive layer of the substrate and the another substrate the topography difference between the chuck and the another chuck. The energy source and the another energy source preferably may have the same characteristics. The substrate with the photosensitive layer and the another substrate with the photosensitive layer preferably may have the same characteristics. The energy source may be a EUV source. The lithographic optical element may be a EUV mask blank. The EUV mask blank may comprise an absorber layer able to absorb part of the electromagnetic radiation, i.e. the EUV part. In this case only the DUV part of the electromagnetic radiation is reflected towards the photosensitive layer.

One inventive aspect relates to an EUV lithographic system, the system comprising at least a first and a second irradiation source, the first irradiation source for EUV lithographic processing of a substrate, the second irradiation source for evaluating a mask or a mask blank.

According to embodiments of the present invention the first irradiation source may be a EUV source emitting electromagnetic radiation comprising a wavelength of approximately 13.5 nm. The EUV source may be used for lithographic processing of the substrate, i.e exposing the substrate typically comprising a resist layer. In a next step developing and etching steps may be performed to further pattern the substrate, as know for a person skilled in the art. According to embodiments the second irradiation source may be a DUV source emitting electromagnetic radiation in a narrow wavelength range centered around 193 nm or centered around 248 nm. According to embodiments evaluating the mask or mask blank may comprise evaluating the topography of the mask or mask blank. According to embodiments evaluating the mask or mask blank may comprise evaluating the topography of the means for holding the mask. The means for holding the mask or mask blank may be a chuck.

The present invention also relates to a lithographic system, the system comprising an irradiation source for generating an irradiation beam, a means for holding a mask or a mask blank, a means for holding a substrate, irradiation optics for guiding the first irradiation beam from the irradiation source towards the substrate via a mask or a mask blank and a second irradiation source for generating a second irradiation beam for evaluating the mask or the mask blank or for evaluating the mask holder. In some embodiments, the wavelength or wavelength range of the second irradiation beam may be substantially longer than the wavelength or wavelength range of the first irradiation beam. Particular and preferred aspects of the invention are set out in the accompanying independent and dependent claims. Features from the dependent claims may be combined with features of the independent claims and with features of other dependent claims as appropriate and not merely as explicitly set out in the claims. For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein, albeit within the scope of the appended claims, without necessarily achieving other objects or advantages as may be taught or suggested herein.

### Brief description of the figures

Figure 1 illustrates a schematic representation of an EUV lithographic system as example of an application system according to embodiments of certain inventive aspects.
Figure 2 shows a schematic flow diagram according to embodiments of certain inventive aspects.
Figure 3a and 3b are a schematically representation of a lithographic optical element for embodiments of certain inventive aspects.
Figure 4 gives a schematic representation for different topography parameters according to embodiments of certain inventive aspects.
Figure 5 gives a schematic representation of a method for determining topography of a lithographic optical element according to embodiments of certain inventive aspects.
Figure 6a and 6b are an example for different curvatures according to embodiments of certain inventive aspects.
Figure 7 shows experimental microscopy images of substrates, the substrates being exposed according to embodiments of certain inventive aspects.
Figure 8 shows a schematic representation of methods according to embodiments of certain inventive aspects for determining the topography of a flat lithographic optical element.
Figure 9 shows a schematic representation of methods according to embodiments of certain inventive aspects for determining the topography of a curved lithographic optical element.
Figure 10 illustrates a schematic representation of a lithographic system as example of an application system according to embodiments of certain inventive aspects.
Figure 11 a and 11 b shows simulation results of a substrate, the simulation done with exposure parameters according to embodiments of certain inventive aspects.

### Description of illustrative embodiments

The present invention will be described with respect to particular embodiments and with reference to certain drawings but the invention is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Furthermore, while some embodiments described herein include some but not other features included in other embodiments, combinations of features of different embodiments are meant to be within the scope of the invention, and form different embodiments, as would be understood by those in the art. Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

The following terms are provided solely to aid in the understanding of the invention.

The term "X-ray radiation" typically includes electromagnetic radiation in the wavelength range 10 nm to 0.01 nm.

The term "extreme ultraviolet radiation" (EUV radiation) comprises electromagnetic radiation in the wavelength range from 10 to 20 nm, also often referred to as the soft X-ray region or vacuum ultraviolet region. EUV radiation thus includes electromagnetic radiation with a wavelength of about 13.5 nm +/-0.3 nm, i.e. the wavelength currently used by EUV lithographic tools.

The term "deep ultraviolet radiation" (DUV radiation) comprises electromagnetic radiation in the wavelength range from 121 nm to 300 nm.

The term "monochromatic" in terms of electromagnetic radiation refers to electromagnetic radiation having a wavelength in a very narrow wavelength range. Although theoretically "monochromatic" electromagnetic radiation refers to electromagnetic radiation having a single wavelength, it is known for a person skilled in the art this is in practice never the case. Also the term "quasi-monochromatic" may be used.

The term "lithographic process system" as referred to in this application is used to define a lithographic exposure tool, such as for example an EUV lithographic exposure tool.

The term "lithographic metrology system" as referred to in this application is used typically for characterization and/or optimization of parameters in a lithographic process or in a lithographic process system.

The term "lithographic optical element" as referred to in this application is used to define an optical element, which is typically used in a lithographic process system. A lithographic optical element may be reflective or non reflective. Depending on the wavelengths of the electromagnetic radiation used in the lithographic process, different optical elements are used. For example, in an EUV lithographic process system, the optical elements presently need to be reflective since a wavelength of approximately 13.5 nm is used in vacuum. At least four optical components are typically used for EUV lithographic exposure: a collector which captures as much radiation from the irradiation source as possible, an irradiation system which homogeneously illuminates the used field on the mask, the mask itself containing the pattern to be transferred to the wafer substrate, and imaging optics which demagnify the structures from the mask to the wafer. For EUV lithography, all these optics presently consist of reflective elements such as mirrors. Also the mask, also often referred to as reticle, is a lithographic optical element, more specifically being a reflective mirror.

An EUV mirror is manufactured as a curved but atomically smooth surface, to which a special multilayered coating is applied. The coating is tuned to give peak reflectivity for just one wavelength of EUV light (i.e. at approximately 13.5 nm).

Alternatively the lithographic optical element may be a lens as used in for example deep ultraviolet (DUV) lithography. DUV lithography uses longer wavelengths (e.g. 248 nm, 193 nm, 157 nm,...) compared to EUV lithography (e.g. 13.5 nm). At these longer wavelengths light may be transmitted by conventional lenses.

The term "(mask) substrate" refers to the base glass or ceramic material upon which films are deposited to make (mask) blanks or masks.

The term "EUV (mask) blank" includes a substrate which has had deposited upon it a backside conductive layer (for electrostatic chucking), a multilayer film stack (to provide high reflection of EUV radiation), and an absorber film stack (to block reflection of light in desired areas). A resist layer for writing a mask pattern is the top most layer. This resist layer is not present anymore on the (patterned) mask.

The term "mask" may be used interchangeable with the term 'reticle'. A reticle is typically a kind of mask used for a stepper or scanner, typically using reduction optics, such that the image on the reticle is magnified. A mask/reticle is a plate with a pattern of transparent and opaque areas used to create patterns on wafers. The term "EUV mask" refers to the final result of patterning an EUV (mask) blank, used in EUV lithography. For EUV lithography, the mask/reticle starts out as a EUV mirror, and the pattern is applied on the top surface as an absorbing layer.

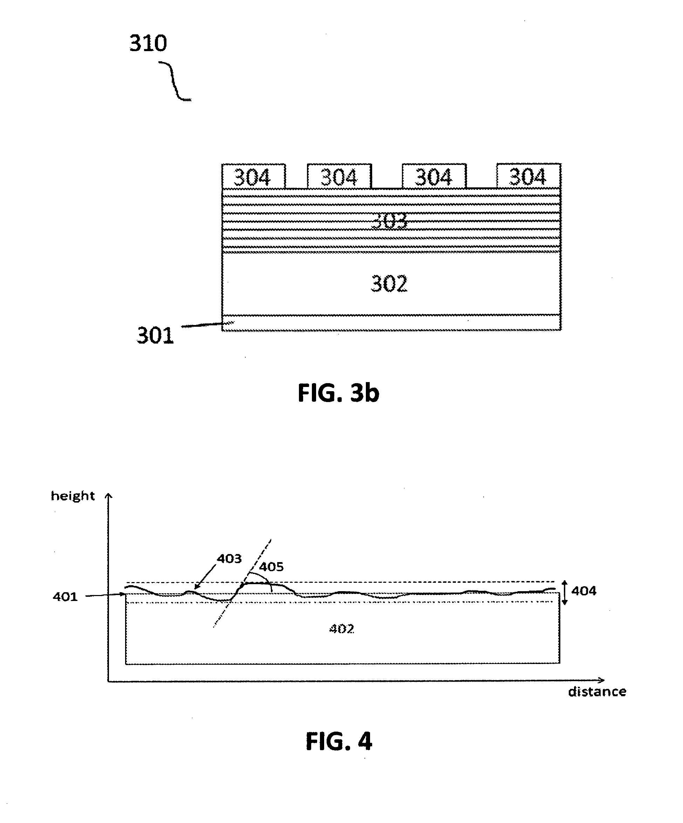

The term "flatness error" is defined as the deviation of the surface in question from the plane that is defined by a least square fit to the flatness data. A substrate bow for example, being any curvature of the substrate which may arise from the deposited films on the backside and topside, will contribute to the flatness error. Fig. 4 gives a schematic overview of the different terms related to flatness of a surface of a substrate 402. The surface may be a backside or frontside surface. The real (curved or non-flat) surface of the substrate 402 is given by line 403. Line 401 defines the least-squares fit plane of the surface of the substrate 402. The peak-to-peak distance 404 of the real surface is the flatness error. Also a local slope angle 405 may be defined as the angle between the local slope and the least squares fit plane 401 of the surface.

The embodiments of inventive aspects are suitable for lithographic systems and methods using electromagnetic radiation with wavelengths having the same order of magnitude or being smaller than the reticle feature thickness. The latter typically includes extreme ultraviolet (EUV) radiation.

The disclosure is related to methods and systems for evaluating the flatness or topography or height or contour or elevation profile of a lithographic optical element. The disclosure is also related to methods and systems for correcting the flatness or topography or height or contour or elevation profile of a lithographic optical element. The disclosure is furthermore related to methods and systems for mask inspection, more specifically for EUV mask inspection. The disclosure is also related to lithographic process systems.

The embodiments of the present invention typically may be related to a lithographic process system. A lithographic process is typically performed in a lithographic process system, also often referred to as lithographic exposure tool. The embodiments of the present invention may also be related to a lithographic metrology system.

The methods and systems according to the embodiments of the present invention will now be explained in more detail with reference to particular embodiments, the present invention not being limited thereto but only being limited by the claims.

The present invention also relates to a lithographic process system for performing lithography. Embodiments of the present invention may in particular relate to extreme ultraviolet radiation (EUV) lithography systems, although not being limited thereto. The system comprises a means for holding a mask or a mask blank, also referred to as a mask holder. The system furthermore comprises a first irradiation source for generating a first irradiation beam for lithographic processing of a substrate and a second irradiation source, different from the first irradiation source, for generating a second irradiation beam. The wavelength or wavelength range of the second irradiation beam typically is substantially longer than a wavelength or wavelength range of the first irradiation beam. The second irradiation beam is provided for evaluating a topography of the mask or the mask blank or the holder thereof. The system also comprises a means for holding a substrate comprising a photosensitive layer for detecting at least part of the second irradiation beam, and irradiation optics for guiding the irradiation beam from the first and second irradiation source towards the photosensitive layer via the mask or the mask blank.

In some embodiments the lithographic system is an EUV lithographic process system, the system comprising at least a first and a second irradiation source, wherein the first irradiation source for EUV lithographic processing of a substrate, the second irradiation source for evaluating a mask or a mask blank or a component of the system holding it, e.g. for evaluating a topography of a mask or a mask blank or a component of the system holding it. Such a component may be a chuck. According to embodiments the first irradiation source is a EUV source emitting electromagnetic radiation comprising a wavelength of approximately 13.5 nm. The EUV source is used for lithographic processing of the substrate, i.e. exposing the substrate typically comprising a resist layer. In a next step developing and etching steps are performed to further pattern the substrate, as know for a person skilled in the art. According to embodiments the second irradiation source is a DUV source emitting electromagnetic radiation in a narrow wavelength range centered around 193 nm or centered around 248 nm.

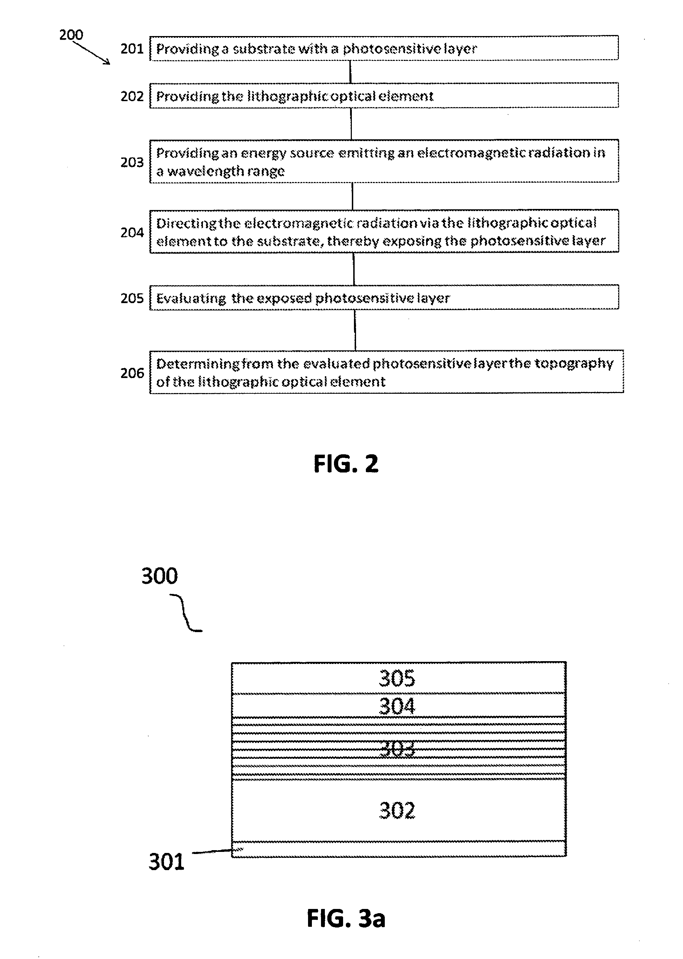

The embodiments of the present invention typically may be used for evaluating topography of masks or mask blanks or components in the lithographic system for supporting such masks or mask blanks. Embodiments of the present invention are especially suitable for use with EUV masks or mask blanks, although embodiments of the present invention are not limited thereto. An EUV mask 310 (Fig. 3b) or EUV mask blank 300 (fig. 3a) typically comprises an EUV substrate 302 which has deposited upon it a backside conductive layer 301, a multilayer film 303, an absorber film stack 304. An EUV mask blank 300 also comprises a resist layer 305 for writing of a mask pattern in the top most layer. The absorber film stack 304 comprises a stack of layers deposited on top of the multilayer stack 303 to block reflection of the electromagnetic radiation. The absorber film stack 304 may also comprise an optional buffer layer (not shown) for use in absorber repair operations. The backside conductive layer 301 comprises a conductive film deposited on the backside of the substrate 302 to enable electrostatic chucking of the substrate during the deposition of the multilayer stack and/or absorber film stack and/or during EUV scanner exposures. The multilayer stack 303 comprises a stack of layers deposited on the substrate to provide high EUV reflectivity. It may also comprise capping layers (not shown) and/or absorber etch stop layers (not shown).

In a lithographic system, a mask or reticle is typically mounted on a chuck in order to securely hold the mask during the lithography process. The surface of the chuck which is in direct contact with the mask is defined as the mounting surface. Typically the backside surface of the mask, which is not patterned, is in direct contact with the mounting surface. For example an electrostatic chuck may be used which holds the mask attached based on electrostatic forces between the chuck and the backside of the mask. Another example may be a mechanical chuck for holding the mask.

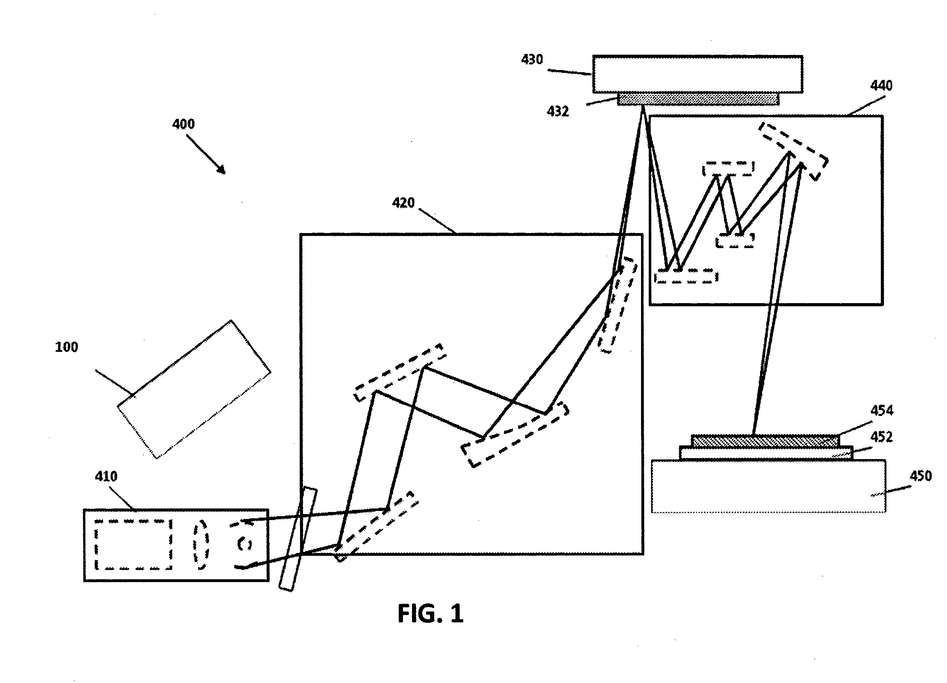

In one particular embodiment, the application system is an extreme ultraviolet lithographic system comprising a plurality of mirrors for guiding the radiation from the radiation source over the reticle to the device to be lithographically processed, and where the resist layer is present. Fig. 1 shows a schematic view of a state of the art example extreme ultraviolet lithography processing system. The system 400 comprises an irradiation source 410, irradiation optics 420 for guiding the irradiation beam from the irradiation source 410 to a reticle stage 430, the reticle stage 430 being adapted for holding a reticle 432. The reticle stage 430 may comprise for example an electrostatic chuck to firmly hold the reticle 432. The system 400 furthermore comprises projection optics 440 for guiding the modulated irradiation beam to the substrate stage 450 adapted for holding a device 452 typically comprising a resist layer 454. The irradiation source 410 is adapted for providing electromagnetic radiation of a wavelength suitable for performing the lithographic processing, such as for example EUV light. The irradiation optics may for example be a laser-fired plasma source, a discharge source, an undulator or wiggler in an electron beam storage ring or synchrotron, etc. The irradiation optics 420 typically comprises one or more filters, mirrors, reflecting surfaces, adjusters, etc. in order to guide the irradiation beam to the reticle stage 430. The irradiation source 410 and irradiation optics 420 typically are such that off-axis irradiation of the reticle is obtained. Typically a lithographic system using short wavelengths according to embodiments of the present invention operates in a reflective mode, i.e. wherein the optical elements typically are reflective elements rather than transmissive elements. The reticle stage 430 may be adapted for holding a reticle 432. It typically comprises a reticle structure according to a reticle pattern used for modulating an irradiation beam in order to generate a pattern in the resist layer 454 of the device 452. The projection optics 440 typically may comprise one or more filters, mirrors, reflecting surfaces, adjusters and possibly lenses. The components in the irradiation optics 420 and the projection optics 440 may introduce typical aberrations in the optical systems, such as e.g. spherical aberrations, astigmatism, coma, etc. The reticle stage 430 and/or the substrate stage 450 may be adapted to provide movement to the reticle respectively the substrate. In embodiments of the present invention, a wafer stepper system as well as a step-and-scan system may be envisaged.

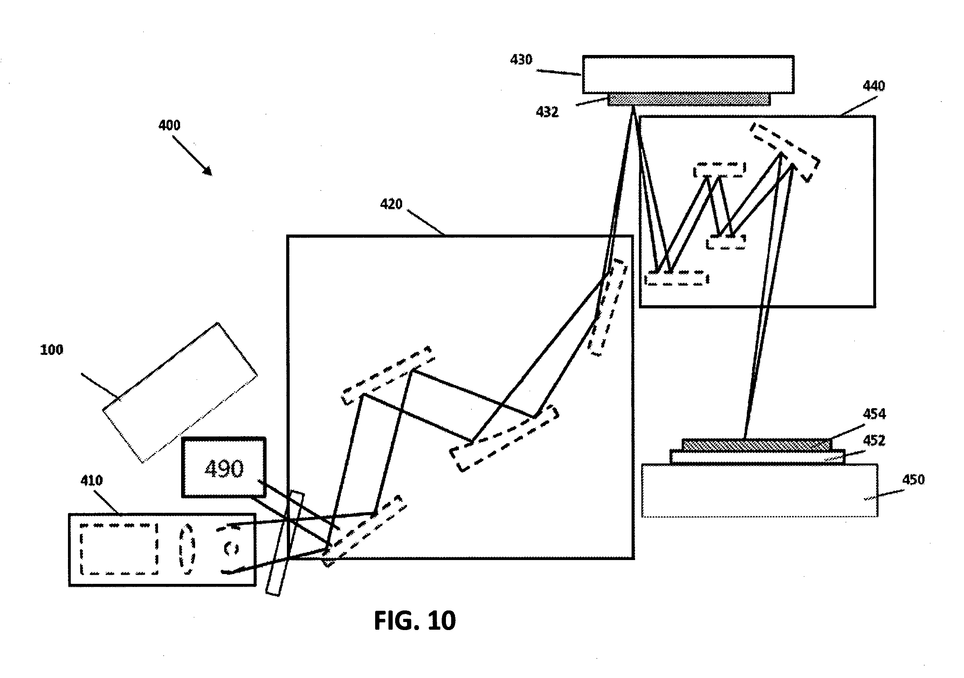

Figure 10 gives a schematic representation of an application system according to certain embodiments of the present invention. All the optics and features present in a state of the art EUV lithographic process system may be present. Additionally another irradiation source 490 is provided in the EUV lithographic process system.

In operation, prior to starting a typical lithographic process (for patterning the substrate) by exposing a substrate (which needs to be patterned according to a certain predetermined pattern) with of the first irradiation source, an exposure using the second irradiation source is performed. A substrate is provided into the system, a mask (which will also be used for the exposing step with the first irradiation source) is provided into the system and the substrate is exposed via the mask using the second irradiation system. By evaluating the exposed substrate one can extract more info on the flatness or topography of the mask or mask blank or chuck. If necessary corrections may be done to the mask or chuck and thereafter another irradiation process, i.e. the actual lithographic processing, may be initiated using the first irradiation source thereby exposing the substrate to be patterned via the mask or corrected mask (or mask blank or chuck).

An inventive aspect relates to a method for evaluating the topography of a lithographic optical element or a holder thereof or more generally a lithographic system. Such methods may for example be especially suitable for evaluating the topography of a mask, mask blank or a holder thereof, although embodiments of the present invention are not limited thereto. The method according to embodiments of the present invention comprises directing electromagnetic radiation of a second wavelength or wavelength range, different from electromagnetic radiation of a first wavelength or wavelength range for lithographic processing in the lithographic system, to a lithographic optical element and detecting at least part of the electromagnetic radiation being reflected from the lithographic optical element at a substrate comprising a photosensitive layer. Thereafter the detected electromagnetic radiation is evaluated and from the evaluation of the exposed photosensitive layer a topographical parameter of the lithographic optical element and/or a holder thereof is determined. By way of illustration, embodiments of the present invention not being limited thereto, an exemplary method is shown in Figure 2, illustrating optional and standard steps of the method 200 for evaluating. According to embodiments obtaining the substrate, obtaining the lithographic optical element and obtaining the energy source may comprise providing the substrate, providing the lithographic optical element and providing the energy source in a lithographic process system and/or a lithographic metrology system. The lithographic process system is preferably an EUV lithographic process system. The steps of obtaining these components may be optional as such components may be pre-installed. These steps will be described below in more detail.

In one optional step 201, the method comprises obtaining a substrate with a photosensitive layer. Obtaining thereby may include providing an off the shelf substrate with a photosensitive layer or may comprise providing a substrate with such a coating and installing it in the system. Alternatively the substrate already may be introduced in the system, such that this step does not need to be performed anymore. A substrate comprising a photosensitive layer is provided. In embodiments, the substrate may include a semiconductor substrate such as e.g. a silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the substrate may be any other base on which a layer is formed, for example a glass or metal layer. Accordingly a substrate may be a wafer such as a blanket wafer or may be a layer applied to another base material, e.g. an epitaxial layer grown onto a lower layer. The substrate is preferably unpatterned. The substrate may be a bare semiconductor wafer.

The substrate with the photosensitive layer is provided in a lithographic optical system and/or a lithographic metrology system. The photosensitive layer is typically a photoresist (also called resist). The photoresist may be positive or negative. The photosensitive layer must at least be sensitive to the electromagnet radiation emitted by the energy source. The photosensitive layer may be provided on the substrate using techniques known for a person skilled in the art, such as for example spin-coating techniques.

The substrate with the photosensitive layer will act as a detector for the method of determining the topography of the lithographic optical element.

In a further optional step 202, the lithographic optical element is obtained in the lithographic optical system and/or a lithographic metrology system.

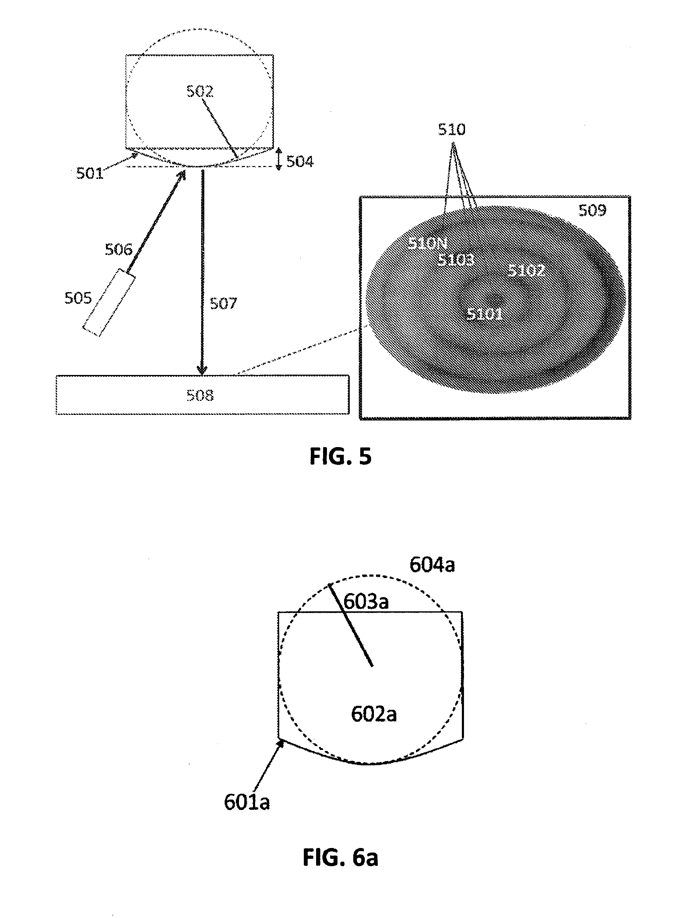

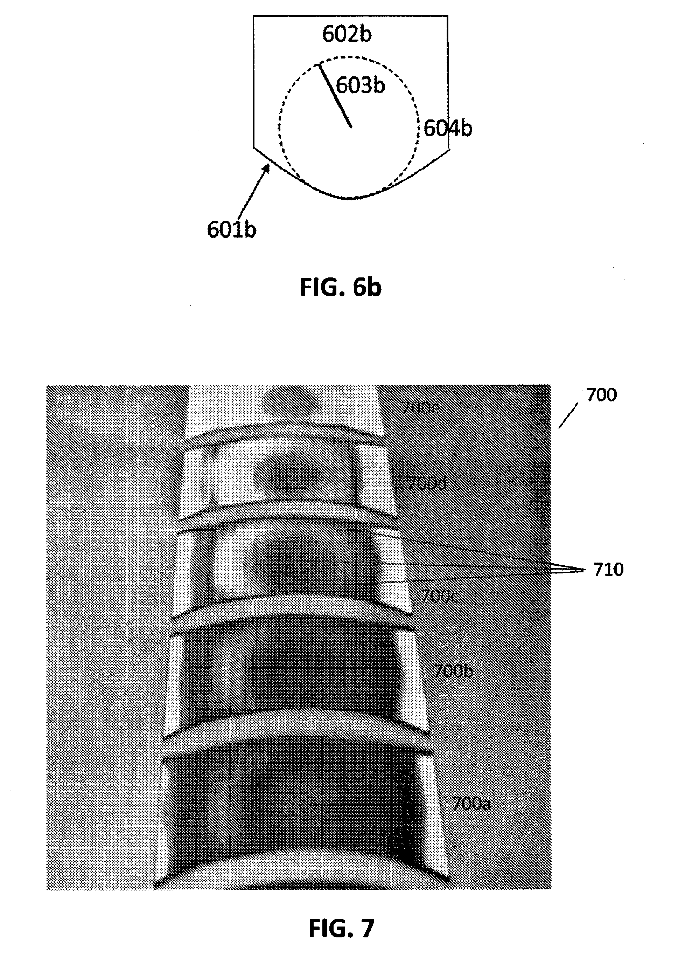

According to embodiments the lithographic optical element is a mask or a mask blank. Preferably the lithographic optical element is a EUV mask or a EUV mask blank. The lithographic optical element comprises a frontside with a topography. The topography may be a curvature of the frontside of the lithographic optical element. The curvature may be convex or concave. For EUV mask or EUV mask blanks the curvature is most often convex. The curvature of the lithographic optical element may be characterized by the radius of curvature R. The larger the curvature the smaller the radius of curvature R. The smaller the curvature the higher the radius of curvature R. This is schematically shown in Fig. 6a en Fig. 6b. A lithographic optical element 602a, 602b with a convex curvature 601 a, 601 b is shown. The curvature 601 a from lithographic optical element 602a is less than the curvature 601 b from lithographic optical element 602b. A surface with a curvature which is less than the curvature of another surface means that the surface is flatter than the another surface. As a consequence the radius of curvature 603a for the lithographic optical element 602a is larger than the radius of curvature 603b for the lithographic optical element 602a. The radius of curvature 603a, 603b is defined by the radius from the circle 604a, 604b which fits in the curvature 601 a, 601 b.

The topography may be a shape of the frontside of the lithographic optical element, the shape comprising different heights of the surface of the frontside. The shape may be defined by a flatness error (as shown in Fig. 4, 404). The shape may be defined by a local slope angle (as shown in Fig. 4, 405). The shape may be defined by a topographic profile, which reflects the contour of the frontside surface of the lithographic element, i.e. the height in function of the distance (as shown in Fig. 4, *403*). The topographic profile or elevation profile or contour profile or height profile may be two dimensional (height versus distance in one direction) or three dimensional (height versus distance in two directions). In a further optional step 203, an energy source is obtained in the optical system and/or a lithographic metrology system. The energy source emits electromagnetic radiation in a wavelength range.According to embodiments the energy source is an EUV source. A EUV lithographic source may emit electromagnetic radiation with a wavelength in a broad range. However for optimal working of the EUV source a spectral purity of the EUV source is necessary with less than 7% of DUV/EUV light (having a DUV wavelength part between 130 and 400 nm). For example a laser-produced plasma (LPP) EUV source may be used, such as a Sn-based LPP EUV source, which has a highly intense emission peak at 13.5 nm. By using a multilayer film in the mask or mask blank, such as for example a Molybdenum/Silicon (Mo/Si) multilayer, a high reflectivity of about 70% may be achieved at a wavelength of 13.5 nm with a 2% bandwidth. Light within 1% bandwidth is called 'in-band' radiation. However the masks also reflect other wavelengths which are known as 'out-of-band' radiation. Out-of-band radiation is generally classified into two bands, a first band from 130 to 400 nm and a second band from 400 nm to infrared and visible radiation.

For determining the topography of the lithographical element, the so called out-of-band radiation of the EUV source, i.e. the DUV wavelength part of the EUV source is of importance.

According to embodiments, where an EUV source is used, the lithographic element is reflective to both the EUV and DUV wavelength part of the electromagnetic radiation.

According to embodiments, where an EUV source is used, the lithographic element may be reflective to the DUV wavelength part of the electromagnetic radiation, but non-reflective to the other wavelengths from the wavelength range of the energy source, i.e. for example non-reflective to the EUV wavelength part of the electromagnetic radiation. The lithographic optical element is then preferably a mask blank with absorber layer, the absorber layer for absorbing the EUV wavelength part, but reflecting the DUV wavelength part.

The EUV source may be identical to the EUV lithographic source used for lithographic processing the substrate in a prior art EUV lithographic process system.

According to embodiments the energy source is a DUV source. The DUV source is preferably emitting an electromagnetic radiation in a quasi monochromatic wavelength range comprising a single wavelength. The DUV source may be an additional source which is provided into a EUV lithographic process system, aside of the EUV lithographic source which is used for standard lithographic processing.

According to embodiments an additional light or energy source 490 may be provided in the lithographic optical system 400, the additional energy source 490 comprising a DUV source (Fig. 10). In this case the lithographic optical system comprises an EUV source 410 which is used for standard lithographic processing of a substrate also known as EUV lithography, and a DUV source 409 (which is different from the EUV source) which is used for evaluating the topography of the lithographic optical element.

According to embodiments the electromagnetic radiation comprises preferably a wavelength band in the range of 130 nm to 400 nm, with a band as narrow as possible. According to embodiments a narrow wavelength band centered around a single wavelength is used. According to embodiments a narrow wavelength band centered around 193 nm (+/- 1 nm) is used. According to embodiments a narrow wavelength band centered around 248 nm (+/- 1 nm) is used. According to embodiments the single wavelength is preferably higher than 2 times the maximum height difference in the topography of the lithographic optical element.

In one step, the method comprises directing 204 the electromagnetic radiation from the energy source or light source to the substrate thereby exposing the photosensitive layer

According to embodiments directing the electromagnetic radiation to the lithographic optical element is according to an angle of about 6 degrees with respect to the plane perpendicular to the surface plane of the lithographic optical element.

The electromagnetic radiation is first directed to the lithographic optical element, more specifically to the frontside of the lithographic optical element and is second reflected from the lithographic optical element, more specifically from the frontside of the lithographic optical element towards the photosensitive layer of the substrate. At least part of the electromagnetic radiation is reflected from the lithographic optical element towards the substrate. If a separate DUV source is used, the electromagnetic radiation directed to the frontside of the lithographic optical element and reflected from the frontside of the lithographic optical element towards the photosensitive layer of the substrate will comprise a DUV wavelength range, more specifically a single wavelength centered around 248 nm or centered around 193 nm. The DUV source is preferably as monochromatic as possible.

If a EUV source is used, the electromagnetic radiation directed to the frontside of the lithographic optical element and reflected from the frontside of the lithographic optical element towards the photosensitive layer of the substrate will comprise an EUV wavelength range, but also a DUV wavelength range. It is the DUV wavelength part of the EUV source which enables the evaluation of the topography of the lithographic optical element. Alternatively the lithographic optical element may comprise an EUV wavelength absorber layer such that only the DUV wavelength part is reflected from the lithographic optical element towards the photosensitive layer of the substrate.

Depending on the energy source, only part of the electromagnetic radiation may reflected from the lithographic optical element towards the photosensitive layer on the substrate or all electromagnetic radiation is reflected from the lithographic optical element towards the photosensitive layer on the substrate. Thereafter the exposed photosensitive layer is evaluated, as indicated in step 205, and the topography of the lithographic optical element or its holder may be determined based on the evaluation of the exposed photosensitive layer, as indicated in step 206).

According to embodiments evaluating the exposed photosensitive layer comprises optically evaluating the exposed photosensitive layer. Optically evaluating may comprise evaluating the exposed photosensitive layer with a microscope, such as for example an atomic force microscope (AFM), an optical microscope, an electron microscopy (for example SEM or TEM), an interferometer,...

According to embodiments evaluating the exposed photosensitive layer may be performed in-situ, i.e. in the lithographic system or ex-situ.

According to embodiments evaluating the exposed photosensitive layer further comprises identifying height differences in the exposed photosensitive layer.

According to embodiments evaluating the exposed photosensitive layer further comprises identifying fringes on the exposed photosensitive layer.

According to embodiments evaluating the exposed photosensitive layer comprises evaluating in 2 dimensions or 3 dimensions.

According to embodiments determining from the evaluation of the exposed resist layer the topography comprises determining a topographical parameter. The topographical parameter may for example be a flatness error or a curvature or a maximum height difference or an root-mean-square (rms) topography value.

According to embodiments the method may further comprise after evaluating the exposed photosensitive layer correcting the lithographic optical element based on the determined topographical parameter. Correcting the lithographic optical element may be done when the determined topographical parameter is larger than a predetermined value. The predetermined value may for example be a flatness error value, a maximum height difference value, a curvature value, an rms-value,...

Surprisingly, due to the interaction of the electromagnetic radiation 506 - comprising a DUV wavelength part - with the front side 501 of the lithographic optical element 502, the resulting pattern 509 on the semiconductor substrate 508 - which is exposed with the electromagnetic radiation 507 being reflected from the lithographic optical element 502 - comprises a series of fringes 510. This series of fringes 510 define the (unknown) topography 501 of the lithographic optical element 502. Otherwise said, the series of fringes 510 on the exposed photosensitive layer 508 are a fingerprint for the topography 501 of the (frontside of the) lithographic optical element 502.

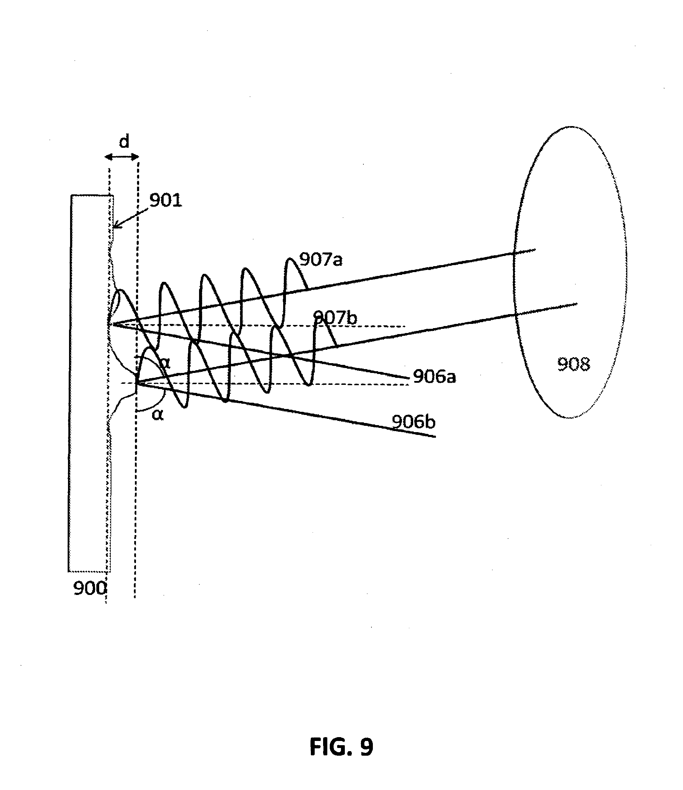

The interaction of the electromagnetic radiation with the front side 501 of the lithographic optical element 502 is based on interference, wherein the energy source acts as a source and the substrate with the photosensitive layer acts as a detector for sensing the topography of the lithographic optical element. Due to the topography of the (front side 501 of) the lithographic optical element 502 the incident electromagnetic waves may be reflected in or out of phase depending on the path difference of these incident electromagnetic waves. If the reflection of the incident electromagnetic waves is in phase, constructive interference will occur resulting in a bright signal (or fringe) in the exposed photosensitive layer. If the reflection of the incident electromagnetic waves is out of phase, destructive interference will occur resulting in a dark signal (or fringe) in the exposed photosensitive layer. The occurrence of light and dark fringes on the photosensitive layer due to the reflected electromagnetic radiation is dependent on the wavelength of the electromagnetic radiation. Constructive interference will occur when the path difference for the reflected electromagnetic waves is an integral number n of the wavelength λ of the electromagnetic waves. The path difference is defined as 2d sin(α), wherein d is the distance between the planes, i.e. the height difference between the planes on which the electromagnetic radiation is impinging. Constructive interference occurs for 2d sin(α) = nλ, with n an integral number. Destructive interference occurs for 2d sin(α) ≠ nλ, with n an integral number. Destructive interference will occur when the path difference for the reflected electromagnetic waves not an integral number n of the wavelength λ of the electromagnetic waves. The interference interaction between electromagnetic radiation, lithographic optical element and substrate with photosensitive layer is shown schematically in figure 9.

In order to be sensitive to a maximum height difference, the maximum height difference (or path difference d) should be smaller than λ/2. For embodiments relating to EUV lithography, SEMI standards require a flatness error smaller than 35 nm, thus the wavelength used should be larger than 70 nm. As a source is used comprising at least a DUV wavelength part, the wavelength of the electromagnetic radiation is larger than 70 nm. Otherwise said, the larger the wavelength of the electromagnetic radiation, the less sensitive for small heights (small path difference).

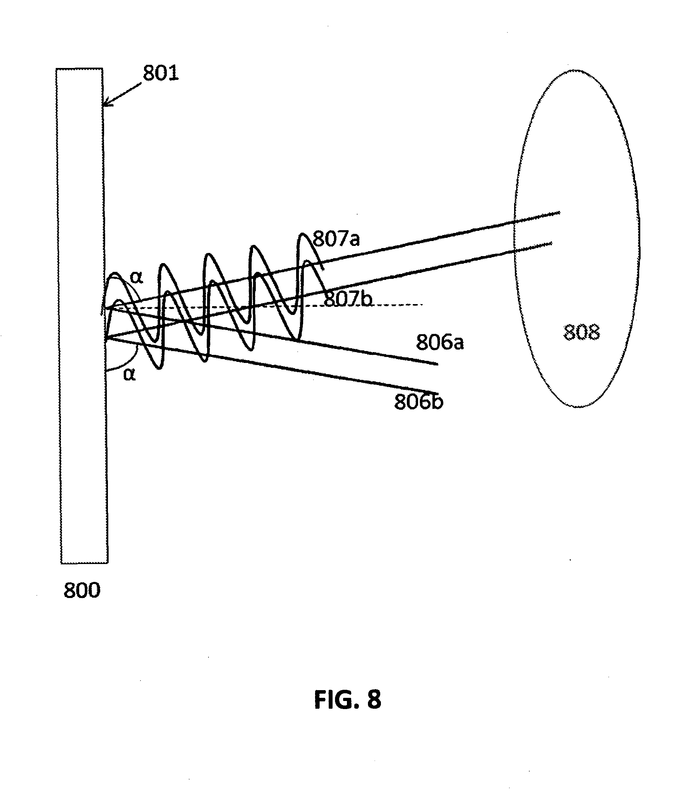

Figure 8 schematically shows the interference which occurs for a flat topography of lithographic optical element. A lithographic optical element 800 is provided with a substantial flat top surface (frontside) 801. Electromagnetic radiation is directed towards the flat top surface, i.e. different electromagnetic waves 806a, 806b impinge on the flat top surface 801. The impinging electromagnetic waves 806a, 806b are reflected from the same plane (since the top surface is flat) towards the substrate 808. As such the reflected electromagnetic waves 807a, 807b are in phase and constructive interference will occur. For this situation the path difference d between the electromagnetic waves 807a, 807b is 0.

Figure 9 schematically shows the interference which occurs for a non-flat lithographic optical element 900, i.e. a lithographic optical element with a surface having a topography 901. A lithographic optical element 900 is provided with a top surface (frontside) with a height profile 901. The impinging electromagnetic waves 906a, 906b are reflected from different planes (due to the height differences of the top surface) towards the substrate 908. As such, depending on the height difference, the reflected electromagnetic waves 907a, 907b may be out of phase and destructive interference will occur. If the path difference d between the electromagnetic waves 907a, 907b is different from 0, and also different from an integral number of the wavelength of the electromagnetic radiation, destructive interference will occur. If the path difference d between the electromagnetic waves 907a, 907b is an integral number of the wavelength of the electromagnetic radiation, constructive interference will occur

The larger the wavelength of the electromagnetic radiation, the better the fringes become visible. As in normal EUV lithography the wavelength of the electromagnetic radiation is very low (approximately 13.9 nm) the fringes are not visible. By applying an electromagnetic radiation with a higher wavelength, i.e. DUV radiation, the fringes become visible. The topography of the mask induces a phase-shift in the light travelling via those height differences of the mask or mask blank.

FIG. 7 shows a microscopy image of part of a semiconductor substrate exposed according to embodiments of certain inventive aspects. 5 sub-images are visible for the same substrate but exposed with an increasing dose going from the bottom sub-image 700a up to the top sub-image 700e. From these experimental measurements it becomes clear one should balance the exposure dose in order to transfer the topography of the reticle to the exposed substrate (with photosensitive layer). The exposure was performed by using the DUV wavelength part from an EUV source. For this example a plasma produced EUV source is used. The reticle is a MoSi multilayer with Ru top surface. In this case the spectral characteristics are exactly known. Circular fringes 510 become visible on the exposed semiconductor substrate after exposure with electromagnetic radiation via a EUV reticle. The scale of the observed fringes is in the range of millimeters.

The amount of fringes and the distance between the subsequent fringes may determine in more detail on the curvature or topography of the lithographic optical element. The determination is based on interference of light physics well known for a person skilled. This phenomenon describes the occurrence of an interference pattern caused by the reflection of light between two surfaces. When monochromatic light is used, a series of concentric, alternating light and black rings (fringes) may become visible. The light rings are caused by constructive interference between the light rays reflected from both surfaces/planes, whereas the dark rings are caused by destructive interference. Also, the outer rings are spaced more closely than the inner ones.

As indicated above, in some embodiments, the electromagnetic radiation source generating electromagnetic radiation for evaluating a topography of the lithographic element or its holder may be a separate source, different from the irradiation source provided for lithographic processing whereas in other embodiments, the electromagnetic radiation source generating electromagnetic radiation for evaluating a topography also generates the electromagnetic radiation for lithographic processing.

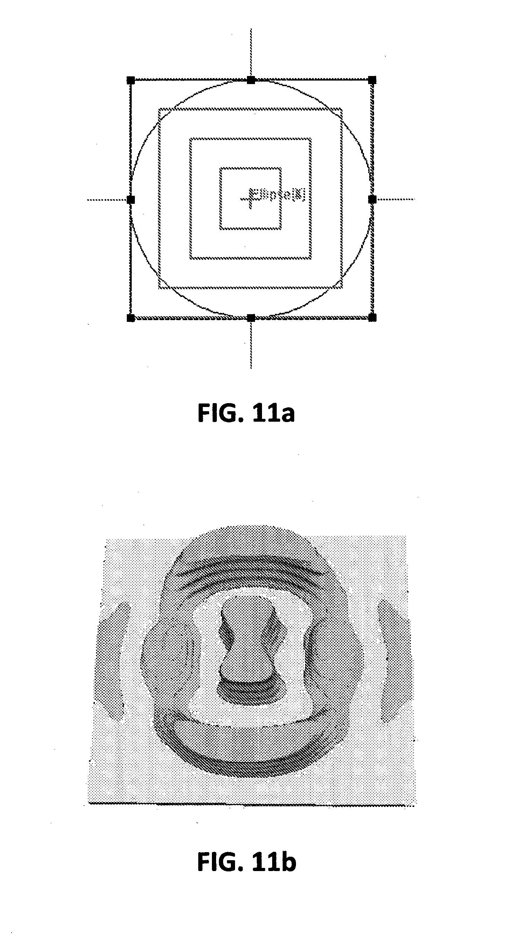

Figure 11b shows simulated results of a series of concentric, alternating light and black rings (fringes) for a wavelength of 250 nm for the electromagnetic radiation. Figure 11a shows the simulated scheme for the lithographic optical element. The figure simulates a height difference, being more specifically a bow or curvature of about 250 nm, with the height difference increasing from inner to outer rectangle. Figure 11b shows the exposure simulation on the substrate for an exposure with a wavelength of 248 nm. From this simulation one can nicely recognize the different fringes, dark and bright, due to the destructive and constructive interference which occurs at the simulated lithographic optical element of Fig. 11a. When fitting this data to the experimental results of Fig. 7, one can see a very good qualitative agreement. From calculations and comparison with other reticle flatness metrology tools, a curvature of about 250 nm is retrieved for the lithographic optical element. By applying, using the methods according to embodiments of the present invention, one may see the topography signature of the chucked lithographic optical element (reticle) on the exposed substrate using an irradiation source emitting electromagnetic radiation in the DUV wavelength range.

According to embodiments a DUV light source may be used in combination with a EUV reticle or mask. The DUV light source may be easily incorporated into the EUV tool next to the EUV source which is used for the lithographic processing of the semiconductor substrate. When emitting DUV light towards the reticle or mask, this DUV light will be reflected towards the semiconductor substrate and form a series of concentric rings which reflect the curvature of the reticle or mask. From the DUV exposure the topography of the EUV reticle may be determined. Before or after the DUV exposure, for determining the topography of the chucked EUV reticle, the EUV source may be applied for the lithographic processing (patterning) of the semiconductor substrate. Based on the evaluation of the exposed substrate from the DUV exposure, the topography of the mask may be corrected or adapted or may be taken into account during further lithographic processing.

According to embodiments an EUV light source may be used in combination with a EUV reticle or mask. The EUV light source is already available in a state-of-the art EUV tool and could thus be used with a two-fold function, i.e. for EUV lithographic processing and/or for determining the topography of the lithographic optical element (for example the chucked reticle). If a EUV light source (comprising a EUV wavelength range and a DUV wavelength range) is used, it is important that the EUV wavelength range is not part of the electromagnetic radiation which is reflected from the lithographic optical element towards the substrate and will not impinge on the semiconductor substrate since the radius of the resulting concentric fringes would be too small to detect. Therefore a EUV absorbing layer may for example be provided on top of the reticle or mask under investigation. The curvature of the top surface of the reticle will also be reflected in the curvature of this EUV absorbing top layer. The reticle or mask should absorb the electromagnetic radiation in the EUV wavelength range, but must reflect the electromagnetic radiation in the DUV wavelength range. This DUV wavelength range part of the electromagnetic radiation is than reflected towards the semiconductor substrate as such creating a topography profile on the substrate which reflects the topography profile of the reticle.

The lithographic exposure for evaluating the topography of the lithographic optical element according to embodiments of the present invention is preferably done in focus. However also from defocus exposure additional information of the topography of the lithographic optical element may be collected.

In particular embodiments, the method allows evaluating the lithographic tool, by performing a tool-to-tool inspection. Comparing for example a photosensitive layer obtained using a method as described above in a first lithographic system with a photosensitive layer obtained using a method as described above in a second lithographic system, may allow for evaluating certain components of the system, such as for example a lithographic optical element or a holder thereof. The latter is typically performed by performing the method as described above in both systems, whereby in both systems elements with similar characteristics are selected, except for the elements that need to be evaluated between the both systems. As described above a reticle is attached with the backside of the reticle to the chuck in a lithographic optical system. Not only the topography of the reticle is important also a topography of the chuck may be present. It is important to take into account the non-flatness of the chuck, which may vary from tool to tool. When comparing a first and a second lithographic optical system, the chuck for both systems may be evaluated and compared by applying a DUV electromagnetic radiation to the chucked reticle and evaluating the exposed substrate. In this case the substrate acts as a detector for determining the topography of the chuck. By using the same or identical lithographic optical element, energy source and substrate with photosensitive layer, the difference in chuck from one tool to another may be determined and if necessary corrected for. Again as already described in detail before, fringes will become visible on the first and the second substrate due to the topography of the chuck. If the first and second chuck differs in topography, this will be seen in a different fringing field on the exposed first and second substrate. By comparing both, one may extract the difference for tool-to-tool chuck.

The present invention also relates to a computer program product for performing, when executed on a processing means, a method for determining topography as described above.

The present invention furthermore relates to a machine readable data storage device storing such a computer program product or the transmission thereof over a local or wide area telecommunications network.

The above described method embodiments for evaluating a lithographic system may be at least partly implemented in a processing system. Also the systems as described above may be implemented as processing system, may be part thereof or may comprise such system. In one configuration of the processing system, at least one programmable processor coupled to a memory subsystem is present that includes at least one form of memory, e.g., RAM, ROM, and so forth. It is to be noted that the processor or processors may be a general purpose, or a special purpose processor, and may be for inclusion in a device, e.g., a chip that has other components that perform other functions. Processing may be performed in a distributed processing manner or may be performed at a single processor. Thus, one or more aspects of the present invention can be implemented in digital electronic circuitry, or in computer hardware, firmware, software, or in combinations of them. The different steps may be computer-implemented steps. The processing system may include a storage subsystem that has at least one disk drive and/or CD-ROM drive and/or DVD drive. In some implementations, a display system, a keyboard, and a pointing device may be included as part of a user interface subsystem to provide for a user to manually input information. Ports for inputting and outputting data also may be included. More elements such as network connections, interfaces to various devices, and so forth, may be included. The memory of the memory subsystem may at some time hold part or all of a set of instructions that when executed on the processing system implement the steps of the method embodiments described herein. A bus may be provided for connecting the components. Thus, a system is described that includes the instructions to implement aspects of the methods for evaluating the lithographic tool or lithographic optical element.

The present invention also includes a computer program product which provides the functionality of any of the methods according to the present invention when executed on a computing device. Such computer program product can be tangibly embodied in a carrier medium carrying machine-readable code for execution by a programmable processor. The present invention thus relates to a carrier medium carrying a computer program product that, when executed on computing means, provides instructions for executing any of the methods as described above. The term "carrier medium" refers to any medium that participates in providing instructions to a processor for execution. Such a medium may take many forms, including but not limited to, non-volatile media, and transmission media. Non-volatile media includes, for example, optical or magnetic disks, such as a storage device which is part of mass storage. Common forms of computer readable media include, a CD-ROM, a DVD, a flexible disk or floppy disk, a tape, a memory chip or cartridge or any other medium from which a computer can read. Various forms of computer readable media may be involved in carrying one or more sequences of one or more instructions to a processor for execution. The computer program product can also be transmitted via a carrier wave in a network, such as a LAN, a WAN or the Internet. Transmission media can take the form of acoustic or light waves, such as those generated during radio wave and infrared data communications. Transmission media include coaxial cables, copper wire and fibre optics, including the wires that comprise a bus within a computer.

It is an advantage of the present invention that the flatness or non-flatness of a lithographic optical element may be monitored in-situ, i.e. in the lithographic process system.

It is an advantage of the present invention that the flatness or non-flatness of a lithographic optical element may be monitored using the light source of the lithographic tool, i.e. the same source used for lithographic process of a semiconductor substrate.

It is an advantage of the present invention that chucking repeatability may be monitored.

It is an advantage of the present invention that lithographic tool-to-tool variations can easily be taken into account when assessing flatness or non-flatness of a lithographic optical element.

It is an advantage of the present invention that the flatness or non-flatness of a lithographic optical element may be characterized with a user-friendly metrology system and a set of tools usually available in a semiconductor manufacturing environment.

It is an advantage of the present invention that overlay errors in the exposed wafer or substrate may be minimized.

It is an advantage of the present invention that results on flatness or non-flatness of a lithographic optical element may be feedback directly to the lithographic process system for any possible correction.

It is to be understood that although preferred embodiments, specific constructions and configurations, as well as materials, have been discussed herein for devices according to the present invention, various changes or modifications in form and detail may be made without departing from the scope and spirit of this invention, the scope of the invention being only limited by the appending claims. Functionality may be added or deleted from the block diagrams and operations may be interchanged among functional blocks. Steps may be added or deleted to methods described within the scope of the present invention, the scope of the invention being only limited by the appending claims.

## Claims

1. A method (200) for evaluating a lithographic system or component thereof, the method (200) comprising
- directing (204) electromagnetic radiation of a second wavelength or wavelength range, different from electromagnetic radiation of a first wavelength or wavelength range for lithographic processing in the lithographic system, to a lithographic optical element and detecting at least part of the electromagnetic radiation being reflected from the lithographic optical element at a substrate comprising a photosensitive layer,
- thereafter evaluating (205) the detected electromagnetic radiation, and
- determining (206) from the evaluation of the exposed photosensitive layer a topographical parameter of the lithographic optical element and/or a holder thereof.

2. A method (200) according to claim 1, wherein the method comprises obtaining (201) the substrate with photosensitive layer, obtaining (202) the lithographic optical element and obtaining (203) an energy source for emitting the electromagnetic radiation of the second wavelength or wavelength range in the lithographic system.

3. A method (200) according to any of the previous claims, wherein the lithographic system is an EUV lithographic system.

4. A method (200) according to claim 3, wherein the electromagnetic radiation of the first wavelength or wavelength range for lithographic processing in the lithographic system is EUV electromagnetic radiation and wherein the electromagnetic radiation of the second wavelength or wavelength range for lithographic processing in the lithographic system is DUV electromagnetic radiation.

5. A method (200) according to claim 4, wherein simultaneously with electromagnetic radiation of the second wavelength or wavelength range, electromagnetic radiation of the first wavelength or wavelength range is directed towards the optical lithographic element, but wherein at least part of the electromagnetic radiation of the first wavelength or wavelength range is absorbed in the optical lithographic element.

6. A method (200) according to any of claims 1 to 5, wherein the electromagnetic radiation of the first wavelength or wavelength range is induced by a different radiation source than the electromagnetic radiation of the second wavelength or wavelength range.

7. A method (200) according to any of the previous claims, wherein evaluating the detected electromagnetic radiation comprises optically evaluating the substrate comprising the photosensitive layer.

8. A method (200) according to claim 7, wherein said optically evaluating comprises in-situ optically evaluating.

9. A method (200) according to any of the previous claims, wherein said evaluating comprises evaluating any of height differences or fringes in the exposed photosensitive layer.

10. A method (200) according to any of the previous claims, the method comprising, after said determining a topographical parameter, correcting the lithographic optical element or a holder thereof taking into account the determined topographical parameter.

11. A method (200) according to any of the previous claims, wherein the lithographic optical element is positioned on a holder, the method further comprising repeating said directing and evaluating step in a second lithographic process system using a lithographic optical element and irradiation sources having the same characteristics, wherein determining a topographical parameter of the lithographic optical element and/or the holder thereof comprises determining a difference in topography between components of the first and second lithographic process system, allowing a lithographic process system tool-to-tool evaluation.

12. A lithographic system (400), the system (400) comprising
- a means for holding (430) a mask or a mask blank
- a first irradiation source (410) for generating a first irradiation beam for lithographic processing of a substrate,
**characterized in that** the system further comprises
- a second irradiation source (490), different from the first irradiation source, for generating a second irradiation beam, a wavelength or wavelength range of said second irradiation beam being substantially longer than a wavelength or wavelength range of the first irradiation beam, for evaluating a topography of the mask or the mask blank,
- a means for holding (450) a substrate comprising a photosensitive layer for detecting at least part of the second irradiation beam, and
- irradiation optics (420) for guiding the irradiation beam from the first and second irradiation source towards the photosensitive layer via the mask or the mask blank.

13. A lithographic system (400) according to claim 12, wherein the lithographic process system (400) is an extreme ultraviolet lithographic process system, the first irradiation source being an irradiation source for extreme ultraviolet lithographic processing of the substrate and wherein the second irradiation source is a deep ultraviolet irradiation source.

14. A lithographic system (400) according to any of claims 12 to 13, wherein the lithographic process system (400) furthermore comprises an EUV filter for temporarily selectively preventing at least part of the first irradiation beam to be incident on the photosensitive layer.

15. A lithographic system (400) according to any of claims 12 to 14, wherein the system (400) furthermore comprises a processing means programmed for evaluating the detected second irradiation beam and for deriving a topographical parameter of the mask or mask blank or its holder in the lithographic process system.

## Patentansprüche

1. Verfahren (200) zum Beurteilen eines Lithografiesystems oder einer Komponente davon, wobei das Verfahren (200) Folgendes umfasst:
- Lenken (204) elektromagnetischer Strahlung einer zweiten Wellenlänge oder eines zweiten Wellenlängenbereichs, von elektromagnetischer Strahlung einer ersten Wellenlänge oder eines ersten Wellenlängenbereichs für die lithografische Bearbeitung in dem Lithografiesystem verschieden, zu einem lithografischen optischen Element und detektieren mindestens eines Teils der von dem lithografischen optischen Element an einem eine lichtempfindliche Schicht umfassenden Substrat reflektierten elektromagnetischen Strahlung,
- danach Beurteilen (205) der detektierten elektromagnetischen Strahlung und
- Bestimmen (206) eines topografischen Parameters des lithografischen optischen Elements und/oder einer Halterung davon anhand der Beurteilung der exponierten lichtempfindlichen Schicht.

2. Verfahren (200) nach Anspruch 1, wobei das Verfahren das Erhalten (201) des Substrats mit der lichtempfindlichen Schicht, das Erhalten (202) des lithografischen optischen Elements und das Erhalten (203) einer Energiequelle zum Emittieren der elektromagnetischen Strahlung der zweiten Wellenlänge oder des zweiten Wellenlängenbereichs in dem Lithografiesystem umfasst.

3. Verfahren (200) nach einem der vorhergehenden Ansprüche, wobei das Lithografiesystem ein EUV-Lithografiesystem ist.

4. Verfahren (200) nach Anspruch 3, wobei die elektromagnetische Strahlung der ersten Wellenlänge oder des ersten Wellenlängenbereichs für die lithografische Bearbeitung in dem Lithografiesystem elektromagnetische EUV-Strahlung ist und wobei die elektromagnetische Strahlung der zweiten Wellenlänge oder des zweiten Wellenlängenbereichs für die lithografische Bearbeitung in dem Lithografiesystem elektromagnetische DUV-Strahlung ist.

5. Verfahren (200) nach Anspruch 4, wobei gleichzeitig mit elektromagnetischer Strahlung der zweiten Wellenlänge oder des zweiten Wellenlängenbereichs elektromagnetische Strahlung der ersten Wellenlänge oder des ersten Wellenlängenbereichs zu dem optischen lithografischen Element geleitet wird, wobei aber mindestens ein Teil der elektromagnetischen Strahlung der ersten Wellenlänge oder des ersten Wellenlängenbereichs in dem optischen lithografischen Element absorbiert wird.

6. Verfahren (200) nach einem der Ansprüche 1 bis 5, wobei die elektromagnetische Strahlung der ersten Wellenlänge oder des ersten Wellenlängenbereichs durch eine andere Strahlungsquelle als die elektromagnetische Strahlung der zweiten Wellenlänge oder des zweiten Wellenlängenbereichs induziert wird.

7. Verfahren (200) nach einem der vorhergehenden Ansprüche, wobei das Beurteilen der detektierten elektromagnetischen Strahlung das optische Beurteilen des die lichtempfindliche Schicht umfassenden Substrats umfasst.

8. Verfahren (200) nach Anspruch 7, wobei das optische Beurteilen ein in situ optisches Beurteilen umfasst.

9. Verfahren (200) nach einem der vorhergehenden Ansprüche, wobei das Beurteilen das Beurteilen einer beliebigen von Höhendifferenzen oder Säumen in der exponierten lichtempfindlichen Schicht umfasst.

10. Verfahren (200) nach einem der vorhergehenden Ansprüche, wobei das Verfahren nach dem Bestimmen eines topografischen Parameters das Korrigieren des lithografischen optischen Elements oder einer Halterung davon unter Berücksichtigung des bestimmten topografischen Parameters umfasst.

11. Verfahren (200) nach einem der vorhergehenden Ansprüche, wobei das lithografische optische Element an einer Halterung positioniert ist, wobei das Verfahren weiterhin das Wiederholen des Lenk- und Beurteilungsschritts in einem zweiten Lithografieprozesssystem unter Verwendung eines lithografischen optischen Elements und von Bestrahlungsquellen mit den gleichen Charakteristika umfasst, wobei das Bestimmen eines topografischen Parameters des lithografischen optischen Elements und/oder der Halterung davon das Bestimmen einer Differenz bei der Topografie zwischen Komponenten des ersten und zweiten Lithografieprozesssystems umfasst, was eine Beurteilung des Lithografieprozesssystems Anlage für Anlage gestattet.

12. Lithografiesystem (400), wobei das System (400) Folgendes umfasst:
- ein Mittel zum Halten (430) einer Maske oder eines Maskenblanks,
- eine erste Bestrahlungsquelle (410) zum Generieren eines ersten Bestrahlungsstrahls für die lithografische Bearbeitung eines Substrats,
**dadurch gekennzeichnet, dass** das System weiterhin Folgendes umfasst:
- eine von der ersten Bestrahlungsquelle verschiedene zweite Bestrahlungsquelle (490) zum Generieren eines zweiten Bestrahlungsstrahls, wobei eine Wellenlänge oder ein Wellenlängenbereich des zweiten Bestrahlungsstrahls wesentlich länger ist als eine Wellenlänge oder ein Wellenlängenbereich des ersten Bestrahlungsstrahls, zum Beurteilen einer Topografie der Maske oder des Maskenblanks,
- ein Mittel zum Halten (450) eines eine lichtempfindliche Schicht umfassenden Substrats zum Detektieren mindestens eines Teils des zweiten Bestrahlungsstrahls und
- eine Bestrahlungsoptik (420) zum Führen des Bestrahlungsstrahls von der ersten und zweiten Bestrahlungsquelle zu der lichtempfindlichen Schicht über die Maske oder den Maskenblank.

13. Lithografiesystem (400) nach Anspruch 12, wobei das Lithografieprozesssystem (400) ein EUV(Extrem Ultraviolet)-Lithografieprozesssystem ist, wobei die erste Bestrahlungsquelle eine Bestrahlungsquelle für die EUV-Lithografieverarbeitung des Substrats ist und wobei die zweite Bestrahlungsquelle eine DUV(Deep Ultraviolet)-Bestrahlungsquelle ist.

14. Lithografiesystem (400) nach einem der Ansprüche 12 bis 13, wobei das Lithografieprozesssystem (400) weiterhin einen EUV-Filter zum vorübergehenden selektiven Verhindern des Auftreffens mindestens eines Teils des ersten Bestrahlungsstrahls auf der lichtempfindlichen Schicht umfasst.

15. Lithografiesystem (400) nach einem der Ansprüche 12 bis 14, wobei das System (400) weiterhin ein Verarbeitungsmittel umfasst, das programmiert ist zum Beurteilen des detektierten zweiten Bestrahlungsstrahls und zum Ableiten eines topografischen Parameters der Maske oder des Maskenblanks oder seiner Halterung in dem Lithografieprozesssystem.

## Revendications

1. Un procédé (200) d'évaluation d'un système lithographique ou d'un composant de celui-ci, le procédé (200) comprenant
- la direction (204) d'un rayonnement électromagnétique d'une deuxième longueur d'onde ou plage de longueurs d'onde, différent d'un rayonnement électromagnétique d'une première longueur d'onde ou plage de longueurs d'onde, pour un traitement lithographique dans le système lithographique, vers un élément optique lithographique et la détection d'au moins une partie du rayonnement électromagnétique qui est réfléchi à partir de l'élément optique lithographique vers un substrat comprenant une couche photosensible,
- ensuite l'évaluation (205) du rayonnement électromagnétique détecté, et
- la détermination (206) à partir de l'évaluation de la couche photosensible exposée d'un paramètre topographique de l'élément optique lithographique et/ou d'un support de celui-ci.

2. Un procédé (200) selon la Revendication 1, où le procédé comprend l'obtention (201) du substrat avec une couche photosensible, l'obtention (202) de l'élément optique lithographique et l'obtention (203) d'une source d'énergie destinée à émettre le rayonnement électromagnétique de la deuxième longueur d'onde ou plage de longueurs d'onde dans le système lithographique.

3. Un procédé (200) selon l'une quelconque des Revendications précédentes, où le système lithographique est un système lithographique par EUV.

4. Un procédé (200) selon la Revendication 3, où le rayonnement électromagnétique de la première longueur d'onde ou plage de longueurs d'onde pour un traitement lithographique dans le système lithographique est un rayonnement électromagnétique à EUV et où le rayonnement électromagnétique de la deuxième longueur d'onde ou plage de longueurs d'onde pour un traitement lithographique dans le système lithographique est un rayonnement électromagnétique à DUV.

5. Un procédé (200) selon la Revendication 4, où simultanément avec un rayonnement électromagnétique de la deuxième longueur d'onde ou plage de longueurs d'onde, un rayonnement électromagnétique de la première longueur d'onde ou plage de longueurs d'onde est dirigé vers l'élément lithographique optique, mais où au moins une partie du rayonnement électromagnétique de la première longueur d'onde ou plage de longueurs d'onde est absorbée dans l'élément lithographique optique.

6. Un procédé (200) selon l'une quelconque des Revendications 1 à 5, où le rayonnement électromagnétique de la première longueur d'onde ou plage de longueurs d'onde est induit par une source de rayonnement différente du rayonnement électromagnétique de la deuxième longueur d'onde ou plage de longueurs d'onde.

7. Un procédé (200) selon l'une quelconque des Revendications précédentes, où l'évaluation du rayonnement électromagnétique détecté comprend une évaluation optique du substrat comprenant la couche photosensible.

8. Un procédé (200) selon la Revendication 7, où ladite évaluation optique comprend une évaluation optique in-situ.

9. Un procédé (200) selon l'une quelconque des Revendications précédentes, où ladite évaluation comprend l'évaluation de tout élément parmi différences de hauteur ou franges dans la couche photosensible exposée.

10. Un procédé (200) selon l'une quelconque des Revendications précédentes, le procédé comprenant, après ladite détermination d'un paramètre topographique, la correction de l'élément optique lithographique ou d'un support de celui-ci en prenant en compte le paramètre topographique déterminé.

11. Un procédé (200) selon l'une quelconque des Revendications précédentes, où l'élément optique lithographique est positionné sur un support, le procédé comprenant en outre la répétition desdites opérations de direction et d'évaluation dans un deuxième système à processus lithographique au moyen d'un élément optique lithographique et de sources d'irradiation possédant les mêmes caractéristiques, où la détermination d'un paramètre topographique de l'élément optique lithographique et/ou du support de celui-ci comprend la détermination d'une différence de topographie entre des composants des premier et deuxième systèmes à processus lithographique, permettant une évaluation outil à outil d'un système à processus lithographique.

12. Un système lithographique (400), le système (400) comprenant
- un moyen de maintien (430) d'un masque ou d'une ébauche de masque
- une première source d'irradiation (410) destinée à générer un premier faisceau d'irradiation pour un traitement lithographique d'un substrat, **caractérisé en ce que** le système comprend en outre
- une deuxième source d'irradiation (490), différente de la première source d'irradiation, destinée à générer un deuxième faisceau d'irradiation, une longueur d'onde ou plage de longueurs d'onde dudit deuxième faisceau d'irradiation étant sensiblement plus longue qu'une longueur d'onde ou plage de longueurs d'onde du premier faisceau d'irradiation, de façon à évaluer une topographie du masque ou de l'ébauche de masque,
- un moyen de maintien (450) d'un substrat comprenant une couche photosensible pour la détection d'au moins une partie du deuxième faisceau d'irradiation, et
- un système optique d'irradiation (420) destiné à guider le faisceau d'irradiation des première et deuxième sources d'irradiation vers la couche photosensible par l'intermédiaire du masque ou de l'ébauche de masque.

13. Un système lithographique (400) selon la Revendication 12, où le système à processus lithographique (400) est un système à processus lithographique par ultraviolets extrêmes, la première source d'irradiation étant une source d'irradiation pour un traitement lithographique par ultraviolets extrêmes du substrat et où la deuxième source d'irradiation est une source d'irradiation à ultraviolets profonds.

14. Un système lithographique (400) selon l'une quelconque des Revendications 12 à 13, où le système à processus lithographique (400) comprend en outre un filtre à EUV destiné à empêcher temporairement de manière sélective au moins une partie du premier faisceau d'irradiation à être incident sur la couche photosensible.

15. Un système lithographique (400) selon l'une quelconque des Revendications 12 à 14, où le système (400) comprend en outre un moyen de traitement programmé de façon à évaluer le deuxième faisceau d'irradiation détecté et à dériver un paramètre topographique du masque ou de l'ébauche de masque ou de son support dans le système à processus lithographique.
